# EUROPÄISCHE PATENTSCHRIFT

(11) **EP 0 468 094 B1**
(45) Veröffentlichungstag und Bekanntmachung des Hinweises auf die Patenterteilung: **11.10.1995**
(21) Anmeldenummer: 90123461.7
(22) Anmeldetag: 06.12.1990
(51) Int. Cl.: H01L 31/032

(54) **Verfahren zur Herstellung einer Chalkopyrit-Solarzelle**
Process for producing a chalcopyrite solar cell
Procédé de fabrication d'une cellule solaire en chalcopyrite

(30) Priorität: 24.07.1990 DE 4023510
(43) Veröffentlichungstag der Anmeldung: 29.01.1992
(73) Patentinhaber: SIEMENS AKTIENGESELLSCHAFT, 80333 München (DE)
(72) Erfinder: Karg, Franz, Dr. rer. nat., W-8000 München 80 (DE)

(56) Entgegenhaltungen:
- EP-A- 0 195 152
- 8TH EC PHOTOVOLTAIC SOLAR ENERGY CONFERENCE, 9. Mai 1988, FLORENCE, ITALY, Seiten 1070-1074; E. NIEMI et al.: 'CuAlSe2 FOR THIN FILMS SOLAR CELLS'
- 7TH EC PHOTOVOLTAIC SOLAR ENERGY CONFERENCE, 27. Oktober 1986, SEVILLA, SPAIN, Seiten 459-464; L. STOLT et al.: 'CuInSe2 AND CuGaSe2 THIN FILM SOLAR CELLS FOR TANDEM STRUCTURES'
- 19TH IEEE PHOTOVOLTAIC SPECIALISTS CONFERENCE, 4. Mai 1987, NEW ORLEANS, US, Seiten 1461-1465; A. NOUHI ET AL.: 'CuInSe2/ZnSe SOLAR CELLS USING REACTIVELY SPUTTER-DEPOSITED ZnSe'
- WORLD PATENTS INDEX LATEST, Section Ch, Week 8241, Oktober 1982; Derwent Publications Ltd., London, GB; Class L, AN 82-87297E & JP-A-53 013 311

## Beschreibung

Die Umwandlung von Licht in elektrische Leistung mittels Solarzellen muß entscheidend verbilligt werden, um mit konventionellen Methoden der Stromerzeugung konkurrieren zu können. Weiterhin werden hocheffiziente Solarzellen mit einem Wirkungsgrad von mindestens 15 Prozent gefordert, um den relativ hohen Flächenbedarf bei der Nutzung der Solarenergie zu begrenzen.

Konventionelle Solarzellen bestehen üblicherweise aus ein- oder polykristallinem Silizium sowie in jüngster Zeit vermehrt auch aus amorphem Silizium. Nachteilig jedoch an diesen Solarzellentypen ist bei den kristallinen und polykristallinen Varianten die teuere Herstellung, bei den amorphen Solarzellen die ungenügende Stabilität und der noch zu geringe Wirkungsgrad.

Gegenstand neuerer Forschungen sind sogenannte Chalkopyrit-Solarzellen, deren Kernstück eine Absorberschicht aus einem I-III-VI₂-Verbindungshalbleiter bildet. In Verbindung mit einer geeigneten Fensterschicht aus einem gitterangepaßten Halbleitermaterial als Emitter- und Oberflächenpassivierungsschicht wird eine funktionsfähige Solarzelle erhalten.

Aus einem Artikel von K. Mitchell et al in IEEE 1988, Seite 1384 bis 1389 ist zum Beispiel eine Solarzelle mit Kupferindiumdiselenid (CIS) als Absorber bekannt. Die Halbleiterschicht ist auf einem mit Molybdän als Rückseitenelektrode beschichteten Glassubstrat in polykristalliner Form aufgebracht. Über dieser p-leitenden CIS-Schicht dient eine dünne n-leitende Cadmiumsulfidschicht als Elektronenemitter und eine Zinkoxidschicht als transparente Elektrode. Ein Alumiumgrid leitet den mit dem bisher höchsten Wirkungsgrad von 14,1 Prozent erzeugten Strom aus der Zelle ab.

Ein großes Problem bei der Herstellung einer Chalkopyrit-Solarzelle ist es, ein als Fensterschicht geeignetes Material zu finden. Um einen an Störstellen armen Übergang zwischen Absorber und Fensterschicht zu erzeugen, werden hohe Anforderungen an das Abscheideverfahren des Fenstermaterials gestellt, dessen Kristallgitter außerdem maximal um 1 Prozent vom Gitter des Absorbers abweichen darf. Weitere Probleme bereitet das Element Cadmium in der Fensterschicht, dessen Umweltunverträglichkeit spezielle Sicherheitsvorkehrungen bei Produktion, Verwendung und Entsorgung der Solarzellen erfordert. Außerdem ist die Komponente Indium in der bekannten CIS-Zelle mit dem bisher höchsten Wirkungsgrad ein relativ seltenes Element, so daß bei der Ausweitung der Produktion Materialengpässe und ein Preisanstieg zu erwarten sind.

Aufgabe der vorliegenden Erfindung ist es daher, ein Verfahren zur Herstellung einer Chalkopyrit-Solarzelle anzugeben, das zu einer Zellenstruktur mit guter Gitteranpassung führt und welches auf die mit Nachteilen behaftete Verwendung der Elemente Cadmium und Indium verzichtet.

Diese Aufgabe wird erfindungsgemäß gelöst durch ein Verfahren mit den Merkmalen von Anspruch 1 oder 2.

Weitere Ausgestaltungen der Erfindung sind den Unteransprüchen zu entnehmen.

Im erfindungsgemäßen Verfahren werden Absorber- und Fensterschicht in einem Schritt in Form einer einheitlichen und homogenen Halbleiterschicht erzeugt. Dabei wird ein Halbleitermaterial erhalten, welches arm an Störstellen ist und daher eine gute elektronische Qualität aufweist. Gegenüber einer getrennten Erzeugung von Absorber- und Fensterschicht aus unterschiedlichen Materialien entfällt nun zusätzlicher apparativer Aufwand zur Erzeugung des zweiten Halbleitermaterials. An dessen Stelle tritt im erfindungsgemäßen Verfahren die Maßnahme des Ionentauschens, welche einfach und mit geringem technischen Aufwand durchzuführen ist. Somit werden zusätzlich Zeit und Kosten gespart.

Das Material der Halbleiterschicht wird im oberen Schichtbereich durch Austausch von Kationen chemisch verändert, wobei entweder durch Einführung geeigneter Kationen in einem relativ dünnen Schichtbereich eine Fensterschicht, oder durch Einführung geeigneter anderer Kationen in einem relativ dicken Bereich auch die Absorberschicht erzeugt werden kann. Im ersten Fall wird dabei von einer Halbleiterschicht aus Kupfergalliumdiselenid ausgegangen, welches mit einem Bandabstand von 1,68 eV eine hohe Absorptionskonstante im sichtbaren Bereich aufweist und daher besonders gut als Absorbermaterial in Solarzellen geeignet ist. Eine passende Fensterschicht dazu stellt zum Beispiel Kupferaluminiumdiselenid dar, welches im erfindungsgemäßen Verfahren durch Austausch der Gallium gegen Aluminiumionen erhalten werden kann. Dieser gezielte Austausch eines von zwei möglichen Kationen gelingt durch Abpufferung des zweiten Kations (Cu⁺) in der wäßrigen Lösung, indem man Kupferionen in einer der Gleichgewichtskonzentration entsprechenden Menge in der Lösung bereithält. Noch einfacher läßt sich das ebenfalls gut als Fenstermaterial geeignete Zinkselenid durch Austausch beider Kationen des Kupfergalliumdiselenids gegen Zink (Zn²⁺) erhalten.

In der alternativen zweiten Ausführungsform der Erfindung wird die Halbleiterschicht aus einem für die Fensterschicht geeigneten Material erzeugt. Ausgehend von Kupferaluminiumdiselenid (CuAlSe₂) wird nachträglich durch Austausch von Aluminium- gegen Galliumionen ein diesmal relativ dicker oberer Schichtbereich in Kupfergalliumdiselenid überführt und so die Absorberschicht erzeugt. Auch dieser Schritt erfordert die Abpufferung der Kupferionen in der Ionenaustauschlösung, um den Austausch von Kupfer in der Halbleiterschicht zu verhindern.

Durch die identischen Kristallgitter der im erfindungslgemäßen Verfahren verwendeten Halbleitermaterialien für Absorber- und Fensterschicht wird garantiert, daß bei dem Ionentausch das Kristallgitter der Halbleiterschicht im oberen Schichtbereich unverändert bleibt. Es können daher keine zusätzlichen Störstellen entstehen, welche mögliche Rekombinationszentren für Ladungsträgerpaare darstellen könnten. Die Qualität des sich an der Grenzfläche zwischen oberem und unterem Schichtbereich ausbildenden Halbleiterübergang (Heteroübergang) ist also nur von der Qualität der zuerst erzeugten Halbleiterschicht abhängig.

Das Verfahren des Ionenaustauschs selbst ist dabei einfach und schnell durchzuführen und läßt sich außerdem gut kontrollieren. Die auszutauschenden "neuen" Ionen werden in einer ausreichenden Konzentration in einer wäßrigen Lösung vorgelegt, in welcher der Austausch bei erhöhter Temperatur zum Beispiel durch Eintauchen der Halbleiterschicht erfolgt. Bei einer entsprechenden Schichtdicke der Halbleiterschicht von ca. 1 bis 5 µm ist der gewünschte Austausch in der zum Beispiel auf 70°C erwärmten Lösung innerhalb weniger Minuten beendet. Höhere Temperatur und höhere Ionenkonzentration der Lösung beschleunigen den Austausch. Die Tiefe des Schichtbereichs, innerhalb dessen es zu einem Austausch der Kationen kommt, läßt sich beispielsweise über die Behandlungsdauer einstellen. Daß dabei im Bereich des Übergangs ein dünner Schichtbereich beobachtet werden kann, in dem "alte" und "neue" Kationen eine Mischphase bilden, ist für die Qualität des Halbleiterübergangs ohne Bedeutung.

Die Dicke der Absorberschicht wird so bemessen, daß einfallendes Sonnenlicht vollständig darin absorbiert wird. Dazu sind 1 bis 2 µm Schichtdicke Kupfergalliumdiselenid ausreichend. Ab einer bestimmten über diesen optimalen Dickenbereich hinausgehenden Schichtdicke wird ein Nachlassen des Wirkungsgrades einer daraus aufgebauten Solarzelle beobachtet. Das Material der Fensterschicht zeigt nur geringe Absorption des sichtbaren Lichtes, da es einen Bandabstand oberhalb 2,5 eV aufweist, beispielsweise 2,7 eV für Kupferaluminiumdiselenid. Die Fensterschicht wird möglichst dünn ausgebildet und beträgt ca. 1 bis 50 Prozent der Gesamtschichtdicke der Halbleiterschicht. Sie sollte aber zumindest so dick sein, daß sie den auf die Fensterschicht entfallenden Anteil der Raumladungszone aufnehmen kann. Ausreichend ist zum Beispiel eine Dicke, die der halben Länge der Raumladungszone entspricht, also etwa 20 bis 100 nm.

Die dem erfindungsgemäßen Verfahren zugrundeliegenden beiden grundsätzlichen Varianten erzeugen zwei verschiedene Typen von Solarzellen. Wird die Halbleiterschicht zunächst aus Fenstermaterial aufgebaut, so muß ein transparentes Substrat mit einer transparenten ersten Elektrodenschicht verwendet werden. Der Lichteinfall bei dieser sogenannten Superstrate-Zelle erfolgt dann durch Substrat, transparente erste Elektroden- und Fensterschichten in die Absorberschicht. Die zweite Variante führt zu einer sogenannten Substratezelle, die auf einem nichttransparenten Substrat mit normaler, üblicherweise metallischer erster Elektrodenschicht aufgebaut werden kann. Der Lichteinfall erfolgt dabei durch die in diesem Fall transparent ausgeführte zweite Elektroden- und die Fensterschicht in die Absorberschicht.

Im folgenden wird die Erfindung anhand von Ausführungsbeispielen und der dazugehörigen Figuren näher erläutert.

Dabei zeigen
- die Figuren 1 bis 3: im schematischen Querschnitt verschiedene Verfahrensstufen beim Aufbau einer erfindungsgemäßen Solarzelle in Superstrate-Anordnung, während
- die Figuren 4 bis 6: verschiedene Verfahrensstufen bei der Herstellung einer erfindungsgemäßen Solarzelle in Substrateanordnung zeigen.

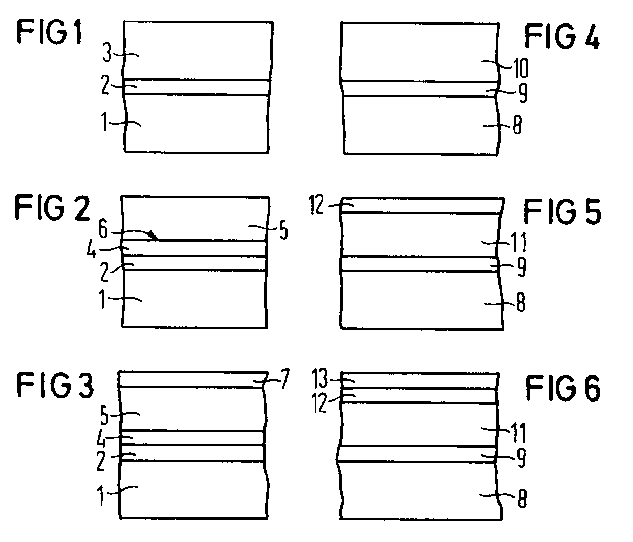

### Herstellung einer Solarzelle in Superstrate-Anordnung (Figuren 1 bis 3):

Als Substrat dient eine Glasplatte 1, die mit einer dünnen Schicht 2 eines transparenten Leiters (TCO) beschichtet wird, beispielsweise mit fluordotiertem Zinnoxid (SnO₂:F). Die Materialien für diese erste Elektrodenschicht 2 und Substrat 1 weisen eine minimale Absorption für sichtbares Licht auf, so daß sie gut für eine durch das Substrat beleuchtete Solarzelle geeignet sind.

Zum Erzeugen der Halbleiterschicht 3 bieten sich erprobte Techniken an, wie sie bereits zur Herstellung von Kupferindiumdiselenid (CIS) erfolgreich verwendet werden. Im vorliegenden Fall wird die Halbleiterschicht aus dem Fenstermaterial polykristallines Kupferaluminiumdiselenid (CuAlSe₂) erzeugt, vorzugsweise durch Aufsputtern metallischer Schichten von Kupfer und Aluminium, welche anschließend in einer Selenwasserstoff enthaltenden Atmosphäre bei ca. 400 bis 500°C getempert werden. Unter diesen Bedingungen werden die metallischen Kupfer- und Aluminium-schichten in die ternäre Verbindung Kupferaluminiumdiselenid überführt. Es entsteht eine homogene polykristalline Halbleiterschicht 3 mit einer Dicke von 1 bis 5 µm, vorzugsweise jedoch von 1 bis 2 µm. In alternativen Methoden zur Erzeugung der Halbleiterschicht 3 kann das Aufsputtern der Kupfer- und Aluminiumschicht durch Aufdampfen ersetzt werden, außerdem kann der Selenisierung in Selenwasserstoffatmosphäre ein Aufdampfen von elementarem Selen vorausgehen. Das Aufsputtern der Schichten hat jedoch den Vorteil, daß sich das Verfahren auch für größere Substratflächen eignet. Figur 1 zeigt die bislang erzeugte Anordnung (1, 2, 3).

Das Material der Halbleiterschicht 3 ist ein Fenstermaterial, welches einen Bandabstand von 2,7 eV aufweist. Ein Teil dieser Halbleiterschicht, nämlich der obere Schichtbereich 5 wird nun in Kupfergalliumdiselenid überführt. Dazu werden die Kupferaluminiumdiselenidschichten in eine wäßrige, Galliumionen enthaltende Lösung eingetaucht, welche auf einer Temperatur von 20 bis 100°C gehalten wird. Neben den hochkonzentrierten Galliumionen enthält die Lösung noch Kupferionen in einer der Gleichgewichtskonzentration. Da Kupferaluminiumdiselenid und Kupfergalliumdiselenid identische Kristallgitter aufweisen, findet der Ionenaustausch von Aluminium gegen Gallium rasch statt und ist nur von der Temperatur der Lösung abhängig. Das Ausmaß des Ionentausches, bzw. die Dicke des ionengetauschten oberen Schichtbereiches 5 wird nach der elektrischen Leitfähigkeit des Fenstermaterials (CuAlSe₂) bemessen, und kann 50 bis 99 Prozent der Gesamtschichtdicke der Halbleiterschicht 3 betragen. Schichten mit schlechterer elektrischer Leitfähigkeit werden vorteilhafterweise dünner ausgeführt. Die gewünschte Dicke wird durch die Parameter der Temperatur und die Zeitdauer des Ionentauschprozesses eingestellt. Typisch für diesen Prozeß sind zum Beispiel eine Temperatur der Lösung von 90°C und eine Dauer von maximal 10 Minuten. Figur 2 zeigt die Anordnung, bei der der obere Schichtbereich 5 der ehemaligen Halbleiterschicht 3 nun in Kupfergalliumdiselenid überführt wurde. Aufgrund der unterschiedlichen elektronischen Leitfähigkeit des im unteren Schichtbereichs 4 unveränderten Fenstermaterials im Vergleich zum p-leitenden Absorbermaterial des oberen Schichtbereichs 5 entsteht an der Grenze zwischen beiden Schichtbereichen ein Heteroübergang 6, um den herum sich eine Raumladungszone ausbildet.

Als letzter Schritt, der zur fertigen Solarzelle führt, erfolgt nun das Erzeugen einer geeigneten, das heißt hochleitfähigen, reflektierenden und nicht in die Halbleiterschicht diffundierenden zweiten Elektrodenschicht 7, welche die Rückelektrode der Solarzelle darstellt. Ein geeignetes Metall, welches diese Voraussetzungen erfüllt und außerdem eine gute Haftung auf Kupfergalliumdiselenid aufweist, ist Molybdän. Figur 3 zeigt den fertigen Aufbau der Solarzelle.

### Herstellung einer Chalkopyrit-Solarzelle in Substrate-Anordnung (Figuren 4 bis 6)

Eine solche Anordnung ist zur Beleuchtung der Solarzelle von der Rückseite her geeignet, so daß von einem nicht transparenten Substrat 8 ausgegangen werden kann. Im ersten Herstellungsschritt wird auf dem elektrisch isolierenden Substrat 8 eine erste Elektrodenschicht 9 aufgebracht, beispielsweise aus einem gut leitenden und hochreflektierenden Metall. Darauf wird eine Halbleiterschicht 10 aus Kupfergalliumdiselenid in einer Stärke von 1 bis 5 µm, vorzugsweise von 1 bis 2 µm abgeschieden. Die Herstellung kann wiederum analog den Verfahren zur Herstellung von CIS erfolgen, bzw. analog zur Herstellung von Kupferaluminiumdiselenid wie im ersten Ausführungsbeispiel. Figur 4 zeigt die Anordnung (8, 9, 10) in diesem Stadium.

Die polykristalline Halbleiterschicht 10, welche einen guten Absorber von 1,68 eV darstellt, wird nun im oberen Schichtbereich 12 durch Ionentausch in eine Fensterschicht überführt. Dazu wird der Ionentausch des ersten Ausführungsbeispiels in umgekehrter Richtung durchgeführt und die Halbleiterschicht 10 in eine Aluminiumionen enthaltende Lösung eingetaucht. Durch Ionentausch wird im oberen Schichtbereich, welcher ca. 1 bis 50 Prozent der Gesamtdicke der Halbleiterschicht 10 ausmacht, eine Kupferaluminiumdiselenidschicht 12 von guter polykristalliner Beschaffenheit erzeugt. Gleichzeitig wird dadurch der Bandabstand im oberen Schichtbereich 12 aufgeweitet, und somit die Fensterschicht der Solarzelle erzeugt (Figur 5).

In einer Variante des Verfahrens kann anstelle des Austausches von Galliumionen gegen Aluminiumionen auch ein Austausch beider Kationen der Schicht 10 (Kupfer und Gallium) gegen Zink erfolgen, wobei im oberen Schichtbereich mit Zinkselenid ein ebenfalls gut als Fenstermaterial geeigneter Halbleiter erzeugt wird. Diese Variante hat den Vorteil, daß keines der Kationen abgepuffert zu werden braucht, und so das Einstellen der Gleichgewichtskonzentration entfallen kann.

Die Figur 6 zeigt eine fertige Solarzelle in der Substrateanordnung, welche als abschließende Schicht eine zweite Elektrodenschicht 13 aufweist. Da die Oberseite nun die Lichteinfallseite darstellt, wird hierfür wiederum transparentes leitfähiges Oxid verwendet. Die Realisierung gelingt zum Beispiel mit Zinkoxid oder Indium-Zinnoxid (ITO).

Alle dargestellten Ausführungsformen der erfindungsgemäßen Chalkopyrit-Solarzelle zeichnen sich durch eine hohe Qualität der Absorberschicht, einen an Störstellen armen Heteroübergang und einen hohen Wirkungsgrad aus. Das Herstellungsverfahren ist gegenüber anderen bekannten, aus Chalkopyritmaterialien bestehenden Solarzellen vereinfacht. Die für den Zellenaufbau verwendeten Verbindungen sind umweltunbedenklich.

## Patentansprüche

1. Verfahren zur Herstellung einer Chalkopyrit-Solarzelle mit einer p-leitenden Kupfergalliumdiselenid-Schicht (5) als Absorber und einer n-leitenden Fensterschicht (4), welches folgende Verfahrensschritte aufweist:
- Erzeugen einer ersten Elektrodenschicht (2) auf einem transparenten elektrisch isolierenden Substrat (1),
- Erzeugen einer Halbleiterschicht (3) aus Kupferaluminiumdiselenid, welches den n-Leitfähigkeitstyp aufweist,
- Behandeln der Halbleiterschicht (3) mit einer Galliumionen enthaltenen wässrigen Lösung, wobei durch Ionenaustausch in einem oberen Schichtbereich (5) Kupfergalliumdiselenid vom p-Leitfähigkeitstyp erzeugt wird und
so ein Heteroübergang zwischen dem einen, die Kupfergalliumdiselenid-Absorberschicht (5) bildenden und dem verbleibenden, die Fensterschicht bildenden Schichtbereich (4) entsteht, und
- Erzeugen einer zweiten Elektrodenschicht auf der Oberfläche der Halbleiterschicht.

2. Verfahren zur Herstellung einer Chalkopyrit-Solarzelle mit einer p-leitenden Kupfergalliumdiselenid-Schicht (11) als Absorber und einer n-leitenden Fensterschicht (12), welches folgende Verfahrensschritte aufweist:
- Erzeugen einer ersten Elektrodenschicht (9) auf einem elektrisch isolierenden Substrat (8),
- Erzeugen einer Halbleiterschicht (10) aus Kupfergalliumdiselenid, welches den p-Leitfähigkeitstyp aufweist,
- Behandeln der Halbleiterschicht (10) mit einer Zink- oder Aluminiumionen enthaltenden wässrigen Lösung, wobei durch Ionenaustausch in einem oberen Schichtbereich (12) ein Halbleitermaterial vom n-Leitfähigkeitstyp erzeugt wird und so ein Heteroübergang zwischen dem einen, die Kupfergalliumdiselenid-Absorberschicht (11) bildenden und dem anderen, die Fensterschicht (12) bildenden Schichtbereich entsteht, und
- Erzeugen einer zweiten Elektrodenschicht (13) auf der Oberfläche der Fensterschicht (12).

3. Verfahren nach Anspruch 1 oder 2, **dadurch gekennzeichnet,** daß zum Erzeugen der Halbleiterschicht (3, 10) zunächst metallisches Kupfer und Aluminium oder Kupfer und Gallium auf die erste Elektrodenschicht (2, 9) aufgesputtert und anschließend bei erhöhter Temperatur mit Selenwasserstoff (H₂Se) behandelt und selenisiert werden.

4. Verfahren nach Anspruch 3, **dadurch gekennzeichnet,** daß die Selenwasserstoffbehandlung bei einer Temperatur von 400 - 500°C durchgeführt wird.

5. Verfahren nach einem der Ansprüche 1 bis 4, **dadurch gekennzeichnet,** daß beim Ionenaustausch im oberen Schichtbereich (5, 12) der Halbleiterschicht (3, 10) das dreiwertige Metallion (Gallium oder Aluminium) ausgetauscht und das Kupfer durch Abpufferung in der Metallionen enthaltenen Lösung vor dem Austauschen geschützt wird.

6. Verfahren nach einem der Ansprüche 2 bis 4, **dadurch gekennzeichnet**, daß die Halbleiterschicht (10) aus Kupfergalliumdiselenid erzeugt und durch den Ionentausch im oberen relativ dünnen Schichtbereich (12) in Kupferaluminiumdiselenid überführt wird, welches die Fensterschicht bildet.

7. Verfahren nach Anspruch 5, **dadurch gekennzeichnet,** daß eine Glasplatte als Substrat (1) mit einer dünnen Schicht eines transparenten leitfähigen Oxids als erste Elektrodenschicht (2) versehen wird, darauf eine Kupferaluminiumdiselenid-Schicht (3) erzeugt wird und durch Austausch von Aluminiumionen gegen Galliumionen der obere Schichtbereich zur Absorberschicht wird.

8. Verfahren nach einem der Ansprüche 2 bis 4, **dadurch gekennzeichnet,** daß die Halbleiterschicht (10) aus Kupfergalliumdiselenid erzeugt wird und beim Ionenaustausch Kupfer- und Galliumionen durch Zinkionen ersetzt werden, wobei eine Zinkselenid-Fensterschicht (12) entsteht.

## Claims

1. Method for producing a chalcopyrite solar cell having a p-conductive copper gallium diselenide layer (5) as an absorber and an n-conductive window layer (4), which has the following procedural steps:
- producing a first electrode layer (2) on a transparent, electrically insulating substrate (1),
- producing a semiconductor layer (3) of copper aluminium diselenide which has the n-conductivity type,
- treating the semiconductor layer (3) with an aqueous solution containing gallium ions, copper gallium diselenide of the p-conductivity type being produced in an upper layer region (5) by ion exchange, and a heterojunction being thus produced between one layer region forming the copper gallium diselenide absorber layer (5) and the remaining layer region (4) forming the window layer, and
- producing a second electrode layer on the surface of the semiconductor layer.

2. Method for producing a chalcopyrite solar cell having a p-conductive copper gallium diselenide layer (11) as an absorber and an n-conductive window layer (12), which has the following procedural steps:
- producing a first electrode layer (9) on an electrically insulating substrate (8),
- producing a semiconductor layer (10) of copper gallium diselenide, which has the p-conductivity type,
- treating the semiconductor layer (10) with an aqueous solution containing zinc or aluminium ions, a semiconductor material of the n-conductivity type being produced in an upper layer region (12) by ion exchange, and a heterojunction thus being produced between one layer region forming the copper gallium diselenide absorber layer (11) and the other layer region forming the window layer (12), and
- producing a second electrode layer (13) on the surface of the window layer (12).

3. Method according to Claim 1 or 2, characterized in that, in order to produce the semiconductor layer (3, 10), metallic copper and aluminium or copper and gallium are first sputtered onto the first electrode layer (2, 9) and subsequently treated with hydrogen selenide (H₂Se) and selenized at elevated temperature.

4. Method according to Claim 3, characterized in that the hydrogen selenide treatment is carried out at a temperature of 400 - 500°C.

5. Method according to one of Claims 1 to 4, characterized in that, in the ion exchange in the upper layer region (5, 12) of the semiconductor layer (3, 10), the trivalent metal ion (gallium or aluminium) is exchanged and the copper is protected from the exchange by buffering in the solution containing metal ions.

6. Method according to one of Claims 2 to 4, characterized in that the semiconductor layer (10) is produced from copper gallium diselenide and is converted by the ion exchange in the upper, relatively thin layer region (12) into copper aluminium diselenide which forms the window layer.

7. Method according to Claim 5, characterized in that a glass plate is provided as the substrate (1) with a thin layer of a transparent conductive oxide as the first electrode layer (2), a copper aluminium diselenide layer (3) is produced thereon and the upper layer region becomes the absorber layer by aluminium ions being replaced by gallium ions.

8. Method according to one of Claims 2 to 4, characterized in that the semiconductor layer (10) is produced from copper gallium diselenide and, during the ion exchange, copper and gallium ions are replaced by zinc ions, a zinc selenide window layer (12) being produced.

## Revendications

1. Procédé de fabrication d'une pile solaire en chalcopyrite, comprenant une couche (5) à conduction p en diséléniure de cuivre et de gallium comme absorbeur et une couche-fenêtre (4) à conduction n, qui comporte les stades de procédé suivants :
- production d'une première couche (2) d'électrode sur un substrat (1) transparent et électriquement isolant,
- production d'une couche semi-conductrice (3) en diséléniure de cuivre et d'aluminium qui a la conductivité de type n,
- traitement de la couche semi-conductrice (3) par une solution aqueuse contenant des ions gallium avec obtention par échange d'ions dans une partie (5) supérieure de la couche de diséléniure de cuivre et de gallium de conductivité de type p et création ainsi d'une hétéro-jonction entre une partie formant la couche d'absorbeur (5) en diséléniure de cuivre et de gallium et la partie (4) restante de couche formant la couche-fenêtre, et
- production d'une deuxième couche d'électrode à la surface de la couche semi-conductrice.

2. Procédé de fabrication d'une pile solaire en chalcopyrite comprenant une couche (11) de conduction p en diséléniure de cuivre et de gallium comme absorbeur et une couche-fenêtre (12) de conduction n qui comporte les stades de procédé suivants :
- production d'une première couche d'électrode (9) sur un substrat (8) électriquement isolant,
- production d'une couche semi-conductrice (10) en diséléniure de cuivre et de gallium qui présente la conductivité de type p,
- traitement de la couche semi-conductrice (10) par une solution aqueuse contenant des ions zinc ou des ions aluminium avec obtention par échange d'ions dans une partie de couche (12) supérieure d'une matière semi-conductrice de conductivité de type n et formation ainsi d'une hétérojonction entre d'une part la partie de couche formant la couche d'absorbeur (11) en diséléniure de cuivre et de gallium et d'autre part la partie de couche formant la couche-fenêtre (12), et
- production d'une deuxième couche d'électrodes (13) à la surface de la couche-fenêtre (12).

3. Procédé suivant la revendication 1 ou 2, caractérisé en ce qu'il consiste pour produire la couche semi-conductrice (3, 10) à déposer par pulvérisation cathodique d'abord du cuivre métallique et de l'aluminium ou du cuivre et du gallium sur la première couche d'électrodes (9) et ensuite à traiter et à séléniser à température haute par de l'hydrogène sélénié (H₂Se).

4. Procédé suivant la revendication 3, caractérisé en ce qu'il consiste à effectuer le traitement par de l'hydrogène sélénié à une température de 400 à 500°C.

5. Procédé suivant l'une des revendications 1 à 4, caractérisé en ce qu'il consiste lors de l'échange d'ions dans la partie de couche (5, 12) supérieure de la couche semi-conductrice (3, 10) à échanger l'ion métallique trivalent (gallium ou aluminium) et à protéger le cuivre de l'échange par tamponnage dans la solution contenant les ions métalliques.

6. Procédé suivant l'une des revendications 2 à 4, caractérisé en ce qu'il consiste à produire la couche semi-conductrice (10) en diséléniure de cuivre et de gallium et à la transformer par échange d'ions dans la partie de couche (12) supérieure relativement mince en diséléniure de cuivre et d'aluminium qui forme la couche-fenêtre.

7. Procédé suivant la revendication 5, caractérisé en ce qu'il consiste à munir une plaque de verre servant de substrat (1) d'une mince couche d'un oxyde transparent et conducteur servant de première couche d'électrode (2), puis à produire dessus une couche (3) de diséléniure de cuivre et d'aluminium et à la transformer en couche d'absorbeur en remplaçant les ions aluminium de la partie supérieure de la couche par des ions gallium.

8. Procédé suivant l'une des revendications 2 à 4, caractérisé en ce qu'il consiste à produire la couche semi-conductrice (10) en diséléniure de cuivre et de gallium et à remplacer par échange d'ions les ions cuivre et gallium par des ions zinc avec formation d'une couche-fenêtre (12) en séléniure de zinc.
